# EUROPÄISCHE PATENTSCHRIFT

(11) **EP 2 583 305 B1**
(45) Veröffentlichungstag und Bekanntmachung des Hinweises auf die Patenterteilung: **09.08.2017**
(21) Anmeldenummer: 11726078.6
(22) Anmeldetag: 26.05.2011
(51) Int. Cl.: H01L 27/15, H01L 33/00, H01L 33/40, H01L 33/38, H01L 31/0224, H01L 31/18, H01L 33/62, H01L 33/44

(54) **VERFAHREN ZUR HERSTELLUNG EINES OPTOELEKTRONISCHEN HALBLEITERCHIPS UND OPTOELEKTRONISCHER HALBLEITERCHIP**
METHOD FOR PRODUCING AN OPTO-ELECTRONIC SEMICONDUCTOR CHIP AND AN OPTO-ELECTRONIC SEMICONDUCTOR CHIP
PROCÉDÉ DE FABRICATION D'UNE PUCE À SEMI-CONDUCTEUR OPTOÉLECTRONIQUE, ET PUCE À SEMI-CONDUCTEUR OPTOÉLECTRONIQUE

(30) Priorität: 17.06.2010 DE 102010024079
(43) Veröffentlichungstag der Anmeldung: 24.04.2013
(73) Patentinhaber: OSRAM Opto Semiconductors GmbH, 93055 Regensburg (DE)
(72) Erfinder: HÖPPEL, Lutz, 93087 Alteglofsheim (DE); VON MALM, Norwin, 93152 Nittendorf - Thumhausen (DE)
(74) Vertreter: Epping - Hermann - Fischer
(86) Internationale Anmeldenummer: PCT/EP2011/058653
(87) Internationale Veröffentlichungsnummer: WO 2011/157523

(56) Entgegenhaltungen:
- DE-A1-102008 022 942
- JP-A- 2009 188 240
- KR-A- 20100 054 756
- US-A1- 2008 241 421
- US-A1- 2009 283 787
- US-A1- 2010 062 554

## Beschreibung

Es wird ein Verfahren zur Herstellung eines optoelektronischen Halbleiterchips angegeben. Darüber hinaus wird ein optoelektronischer Halbleiterchip angegeben.

Das Stand-der-Technik-Dokument US 2009/283787 A1 (M. Donofrio et al), veröffentlicht am 19. November 2009, offenbart ein Herstellungsverfahren eines Leuchtdiodenhalbleiterchips mit Titan- oder Titan-Aluminium-Legierungs-Durchkontakt zur n-leitenden Schicht durch die p-leitende Schicht.

Eine zu lösende Aufgabe besteht darin, ein Verfahren zur besonders kostengünstigen Herstellung eines optoelektronischen Halbleiterchips anzugeben. Ferner besteht eine zu lösende Aufgabe darin, einen optoelektronischen Halbleiterchip anzugeben, der besonders einfach und damit kostengünstig herstellbar ist.

Gemäß zumindest einer Ausführungsform des Verfahrens zur Herstellung eines optoelektronischen Halbleiterchips umfasst das Verfahren die folgenden Schritte:
Zum Beispiel in einem ersten Verfahrensschritt wird eine n-leitende Schicht bereitgestellt. Die n-leitende Schicht ist beispielsweise mit einem n-dotierten Halbleitermaterial gebildet. Die n-leitende Schicht kann beispielsweise auf ein Aufwachssubstrat epitaktisch abgeschieden werden.

In einem beispielsweise nachfolgenden Verfahrensschritt wird eine p-leitende Schicht auf der n-leitenden Schicht angeordnet. Die p-leitende Schicht ist beispielsweise durch eine p-dotierte Halbleiterschicht gebildet, die ebenfalls epitaktisch abgeschieden wird.

Zwischen der n-leitenden Schicht und der p-leitenden Schicht ist vorzugsweise zumindest eine aktive Zone ausgebildet, die im Betrieb des optoelektronischen Halbleiterchips zum Empfang und/oder zur Emission von elektromagnetischer Strahlung vorgesehen ist.

Die Halbleiterschichten des optoelektronischen Halbleiterchips, also beispielsweise die n-leitende Schicht, die p-leitende Schicht und die aktive Zone, basieren vorliegend beispielsweise auf einem Nitrid-Halbleiter. Das bedeutet, dass die Schichten oder zumindest Teile davon, insbesondere auch die aktive Zone, ein Nitrid-Verbindungshalbleitermaterial wie AlₙGaₘIn₁₋ₙ₋ₘN aufweisen oder aus diesem Material bestehen, wobei 0 ≤ n ≤ 1, 0 ≤ m ≤ 1 und n + m ≤ 1. Dabei muss dieses Material nicht zwingend eine mathematisch exakte Zusammensetzung nach obiger Formel aufweisen. Vielmehr kann es beispielsweise ein oder mehrere Dotierstoffe sowie zusätzliche Bestandteile aufweisen. Der Einfachheit halber beinhaltet obige Formel jedoch nur die wesentlichen Bestandteile des Kristallgitters, auch wenn diese teilweise durch geringe Mengen weiterer Stoffe ersetzt und/oder ergänzt sein können.

Gemäß zumindest einer Ausführungsform des Verfahrens wird in einem weiteren Verfahrensschritt eine Metallschichtenfolge auf der p-leitenden Schicht angeordnet. Die Metallschichtenfolge kann dabei direkt auf der p-leitenden Schicht abgeschieden werden, es ist jedoch auch möglich, dass eine oder mehrere Zwischenschichten zwischen der Metallschichtenfolge und der p-leitenden Schicht angeordnet sind.

Gemäß zumindest einer Ausführungsform des Verfahrens umfasst die Metallschichtenfolge zumindest eine Spiegelschicht und zumindest eine Sperrschicht, wobei die Spiegelschicht der Metallschichtenfolge der p-leitenden Schicht zugewandt ist. Die Spiegelschicht der Metallschichtenfolge ist beispielsweise mit Silber gebildet, das heißt die Spiegelschicht enthält in diesem Fall Silber oder besteht aus Silber. Die Sperrschicht kann der Spiegelschicht an ihrer der p-leitenden Schicht abgewandten Oberfläche direkt nachfolgen. Die Sperrschicht dient beispielsweise dazu, eine Diffusion von Silber zu hemmen oder zu unterdrücken. Die Sperrschicht unterdrückt insbesondere auch die Diffusion von anderen Materialien in die Spiegelschicht hinein. Beispielsweise enthält oder besteht die Sperrschicht aus TiWN oder TiN. Ferner ist es möglich, dass die Sperrschicht ein transparentes, leitfähiges Oxid enthält oder aus einem solchen besteht. Zum Beispiel enthält die Sperrschicht dann ZnO oder besteht die Sperrschicht aus ZnO.

Gemäß zumindest einer Ausführungsform des Verfahrens wird an der der p-leitenden Schicht abgewandten Seite der Metallschichtenfolge eine Maske angeordnet. Die Maske wird beispielsweise aus einem Fotolack strukturiert und kann geschlossene Bereiche aufweisen, in denen sie die Metallschichtenfolge abdeckt, sowie offene Bereiche, in denen die Metallschichtenfolge frei zugänglich ist.

Gemäß zumindest einer Ausführungsform des Verfahrens wird die Metallschichtenfolge unter Verwendung der Maske stellenweise abgetragen, beispielsweise dort, wo die Metallschichtenfolge nicht von der Maske abgedeckt ist. Durch dieses Abtragen wird die p-leitende Schicht, an den Stellen, an denen die Metallschichtenfolge entfernt wird, freigelegt.

Beispielsweise erfolgt die Strukturierung der Metallschichtenfolge nasschemisch oder durch Rücksputtern. Gemäß zumindest einer Ausführungsform des Verfahrens werden die freigelegten Bereiche der p-leitenden Schicht stellenweise neutralisiert. Das Neutralisieren geschieht dabei, ohne dass eine weitere Maske definiert wird. Vielmehr wird die bereits für das Strukturieren der Metallschichtenfolge verwendete Maske für das Neutralisieren der freigelegten Bereiche der p-leitenden Schicht verwendet. Alternativ ist es möglich, dass die nicht entfernten Bereiche der Metallschichtenfolge als Maske für die Strukturierung der p-leitenden Schicht Verwendung finden.

Wichtig ist dabei, dass die Strukturierung der Metallschichtenfolge sowie die Strukturierung der p-leitenden Schicht ohne die Definition einer weiteren Maske zwischen den beiden Verfahrensschritten erfolgt, das heißt die Strukturierung der Metallschichtenfolge sowie die Strukturierung der p-leitenden Schicht erfolgen mit derselben Fototechnik. Vorteilhaft ist die Strukturierung der p-leitenden Schicht daher selbstjustierend zur bereits strukturierten Metallschichtenfolge. Insgesamt erweist sich der Verzicht auf eine weitere Fototechnik als eine Möglichkeit zur Reduzierung des Produktionsaufwands für die Herstellung des optoelektronischen Halbleiterchips, was zu reduzierten Kosten bei der Herstellung des optoelektronischen Halbleiterchips führt.

Das Neutralisieren der freigelegten Bereiche der p-leitenden Schicht erfolgt beispielsweise durch Rücksputtern mit Ar-Ionen und/oder Wasserstoffionen. Beim Neutralisieren der p-leitenden Schicht wird der p-Dotierstoff in der p-leitenden Schicht neutralisiert, sodass die neutralisierten Bereiche der p-leitenden Schicht elektrisch isoliert werden. Die Neutralisierung der freigelegten Bereiche der p-leitenden Schicht erfolgt bis zur n-leitenden Schicht, sodass diese über die neutralisierten Bereiche kontaktierbar wird. Beim Neutralisieren der p-leitenden Schicht wird der neutralisierte Bereich der p-leitenden Schicht stellenweise n-leitend dotiert, sodass eine Kontaktierung der n-leitenden Schicht durch den neutralisierten Bereich hindurch erfolgt. Beim Neutralisieren der freigelegten Bereiche der p-leitenden Schicht wird in der an die neutralisierten Bereiche angrenzenden p-leitenden Schicht eine Kante erzeugt.

Es wird darüber hinaus ein optoelektronischer Halbleiterchip angegeben. Der optoelektronische Halbleiterchip ist mit dem hier beschriebenen Verfahren herstellbar. Das heißt, die für das Verfahren offenbarten Merkmale sind auch für den optoelektronischen Halbleiterchip offenbart und umgekehrt. Gemäß zumindest einer Ausführungsform des optoelektronischen Halbleiterchips umfasst der optoelektronische Halbleiterchip die Metallschichtenfolge, die zumindest eine Spiegelschicht und eine Sperrschicht umfasst, und die p-leitende Schicht. Dabei ist die Spiegelschicht der Metallschichtenfolge der p-leitenden Schicht zugewandt und die p-leitende Schicht überragt die Spiegelschicht seitlich. Mit anderen Worten ist die Spiegelschicht gegenüber der p-leitenden Schicht in lateraler Richtung zurückgezogen. "Seitlich" oder "laterale Richtung" bezeichnet dabei Richtungen, die zum Beispiel senkrecht zu einer Wachstumsrichtung der epitaktisch hergestellten Schichten verlaufen.

Der seitliche Überstand der p-leitenden Schicht über die Spiegelschicht beträgt zum Beispiel höchstens 5 µm, vorzugsweise höchstens 3 µm, beispielsweise höchstens 2 µm. Die Tatsache, dass die p-leitende Schicht die Spiegelschicht zumindest stellenweise überragt, ist dadurch bedingt, dass das Abtragen der Metallschichtenfolge und das Neutralisieren der durch das Abtragen freigelegten Bereiche der p-leitenden Schicht in einem Arbeitsschritt, unter Verwendung der gleichen Maske, erfolgen. Es ist möglich, dass der Überstand der p-leitenden Schicht zu anderen Schichten der Metallschichtenfolge als der Spiegelschicht kleiner ist als der Überstand zur Spiegelschicht. Beispielsweise kann die Sperrschicht seitlich die Spiegelschicht der Metallschichtenfolge überragen, sodass die p-leitende Schicht die Sperrschicht um einen kleineren Betrag seitlich überragt als die Spiegelschicht oder die Sperrschicht und die p-leitende Schicht zumindest stellenweise sogar bündig miteinander abschließen. Beispielsweise überragt die Sperrschicht die Spiegelschicht seitlich, wobei der Überstand der Sperrschicht über die Spiegelschicht höchstens 1 µm beträgt. Der Überstand der Sperrschicht über die Spiegelschicht kann beispielsweise dadurch bedingt sein, dass ein Ätzmittel zur Strukturierung der Metallschichtenfolge die Spiegelschicht stärker angreift als die Sperrschicht.

Die p-leitende Schicht überragt die Spiegelschicht vorzugsweise entlang aller Kanten der p-leitenden Schicht, an denen diese an Bereiche grenzt, in denen die p-leitende Schicht neutralisiert ist.

Im Folgenden werden Ausführungsformen angegeben, die sich sowohl auf das hier beschriebene Verfahren zur Herstellung eines optoelektronischen Halbleiterchips als auch auf den hier beschriebenen optoelektronischen Halbleiterchip beziehen. Das heißt, die nachfolgenden Merkmale sind sowohl für das Verfahren als auch für den optoelektronischen Halbleiterchip offenbart.

Gemäß zumindest einer Ausführungsform ist eine Öffnung ausgebildet, die sich durch die n-leitende Schicht und die p-leitende Schicht erstreckt. Das heißt, die n-leitende Schicht und die p-leitende Schicht sind im Bereich der Öffnung stellenweise entfernt. Beispielsweise erstreckt sich die Öffnung ausgehend von der n-leitenden Schicht durch die p-leitende Schicht hindurch bis zur Metallschichtenfolge, sodass an einer Bodenfläche der Öffnung eine Schicht der Metallschichtenfolge freigelegt ist. Beispielsweise kann sich die Öffnung dabei von der n-leitenden Schicht aus in Richtung zur Metallschichtenfolge hin verjüngen. An der Bodenfläche der Öffnung, also zur freigelegten Schicht der Metallschichtenfolge hin, ist eine Anschlussfläche zur elektrischen Kontaktierung des Halbleiterchips ausgebildet.

Mit anderen Worten kann eine Schicht der Metallschichtenfolge als Anschlussfläche (so genanntes Bond Pad) zur elektrischen Kontaktierung des Halbleiterchips dienen. Dabei ist es auch möglich, dass auf der Schicht der Metallschichtenfolge direkt eine Metallisierung aufgebracht ist, welche die Anschlussfläche bildet. In jedem Fall dient die Metallschichtenfolge, das heißt zumindest die freigelegte Schicht der Metallschichtenfolge, zur Einprägung und gegebenenfalls Verteilung von Strom im optoelektronischen Halbleiterchip. Auf diese Weise ist es möglich, während des Herstellungsverfahrens des optoelektronischen Halbleiterchips auf die separate Definition einer Anschlussfläche zu verzichten, was wiederum zu einer Reduzierung des Produktionsaufwandes und damit zu einer besonders kostengünstigen Herstellung des optoelektronischen Halbleiterchips führt.

Gemäß zumindest einer Ausführungsform erstreckt sich die Öffnung zumindest teilweise durch die Spiegelschicht der Metallschichtenfolge hindurch, wobei Seitenflächen der Öffnung zumindest im Bereich der Spiegelschicht vollständig von einer Passivierungsschicht bedeckt sind. Das heißt, im Bereich der Öffnung kann die Spiegelschicht der Metallschichtenfolge entfernt sein. Beispielsweise ist an der Bodenfläche der Öffnung dann die Sperrschicht oder eine weitere Schicht der Metallschichtenfolge freigelegt. Um die Spiegelschicht vor schädlichen atmosphärischen Gasen und Feuchtigkeit zu schützen, sind vorliegend die im Bereich der Öffnung freigelegten Bereiche der Spiegelschicht vollständig mit einer Passivierungsschicht zu bedecken. Beispielsweise wird die Passivierungsschicht dabei mittels eines ALD (Atomic Layer Deposition)-Prozesses erzeugt. Ein ALD-Verfahren eignet sich besonders gut zur konformen Umformung der Spiegelschicht, ohne dass in der Passivierungsschicht Kanäle auftreten, durch die Material von der Spiegelschicht nach außen oder zur Spiegelschicht hin gelangen kann. Das heißt, die derart hergestellte Passivierungsschicht schützt den Spiegel vor Schadstoffen, wie zum Beispiel Gase und/oder Feuchtigkeit. Ferner behindert oder verhindert die Passivierungsschicht die Migration von Bestandteilen der Spiegelschicht - zum Beispiel Silberionen - in angrenzende Bereiche des Halbeiterchips.

Die Herstellung der Passivierungsschicht mittels eines ALD-Prozesses lässt sich dabei eindeutig beispielsweise mittels elektronenmikroskopischer Aufnahmen von Passivierungsschichten, die durch andere Herstellungsprozesse wie beispielsweise CVD (Chemical Vapour Deposition) erzeugt sind, unterscheiden. Bei dem Merkmal, dass die Passivierungsschicht mittels eines ALD-Prozesses erzeugt ist, handelt es sich daher auch um ein gegenständliches Merkmal und nicht um ein reines Verfahrensmerkmal.

Gemäß zumindest einer Ausführungsform überragt die p-leitende Schicht die Spiegelschicht in der Öffnung seitlich. Die p-leitende Schicht überragt die Spiegelschicht dabei vorzugsweise seitlich umlaufend mit einem Überstand von wenigstens 500 nm, beispielsweise 1 µm, höchstens zum Beispiel 4 µm. Ist die Passivierungsschicht mittels eines ALD-Prozesses erzeugt, so erstreckt sich die Passivierung unter den Überstand der p-leitenden Schicht über die Spiegelschicht bis zur Spiegelschicht selbst und überdeckt diese formschlüssig.

Dabei ist es möglich, dass der durch den Überstand der p-leitenden Schicht über die Spiegelschicht gebildete Hohlraum vollständig mit dem Material der Passivierungsschicht ausgefüllt ist. Insbesondere bei der Verwendung eines ALD-Prozesses zur Herstellung der Passivierungsschicht ist es jedoch auch möglich, dass sich unterhalb der p-leitenden Schicht eine Hohlkehle ausbildet. Die Passivierungsschicht weist dann beispielsweise einen U-förmigen Querschnitt auf. Sie bedeckt die p-leitende Schicht im Bereich des Überstands an ihrer der Metallschichtenfolge zugewandten Seite, die Spiegelschicht im Bereich der Seitenfläche der Öffnung und die freigelegte Schicht der Metallschichtenfolge, die der p-leitenden Schicht im Bereich des Überstands zugewandt ist, vollständig.

Gemäß zumindest einer Ausführungsform schließt die Seitenfläche der Öffnung im Bereich der Spiegelschicht einen anderen Winkel mit der der Spiegelschicht zugewandten Oberfläche eines Trägers des Halbleiterchips ein als die Seitenfläche der Öffnung im Bereich der p-leitenden Schicht.

Zum Beispiel verläuft die Seitenfläche der Öffnung im Bereich der Spiegelschicht senkrecht zur Oberfläche des Trägers, wohingegen die Seitenfläche der Öffnung im Bereich der p-leitenden Schicht einen Winkel ungleich 90° mit der Oberfläche des Trägers einschließt. Zum Beispiel ist die Öffnung im Bereich der Metallschichtenfolge zylinderförmig oder quaderförmig und ansonsten kegelstumpfförmig oder pyramidenstumpfförmig ausgebildet. Ein seitliches Überragen der Spiegelschicht durch die p-leitende Schicht in der Öffnung ist auf diese Weise besonders einfach zu realisieren.

Gemäß zumindest einer Ausführungsform liegt eine Dicke der Passivierungsschicht zwischen einschließlich 20 nm und 100 nm, insbesondere zwischen einschließlich 35 nm und 70 nm. Die Dicke der Passivierungsschicht ist hierbei insbesondere zu messen in einer Richtung parallel zu einer Wachstumsrichtung der Passivierungsschicht. Weist die Passivierungsschicht mehrere zusammengewachsene Teilbereiche auf, so ist die Dicke insbesondere jeweils für die einzelnen Teilbereiche zu bestimmen, zum Beispiel bis hin zu einer Naht, an der die einzelnen Teilbereiche aneinander grenzen. Die Spiegelschicht weist bevorzugt eine Dicke zwischen einschließlich 100 nm und 200 nm auf, insbesondere zwischen einschließlich 100 nm und 150 nm.

Gemäß zumindest einer Ausführungsform umfasst die Passivierungsschicht oder besteht die Passivierungsschicht aus einem Siliziumoxid, einem Aluminiumoxid und/oder einem Zirkoniumoxid. Ebenso kann die Passivierungsschicht eines der folgenden Materialien umfassen oder hieraus bestehen: TiO₂, HfO₂, SnO₂, SiC, Zr(SiO₄), Pb₃(Si₂O₇), Na(AlSiO₄), Si₃N₄, AlN, GaN. Auch andere transparente, feuchtestabile Oxide, Carbide und/oder Nitride können für die Passivierungsschicht Verwendung finden.

Gemäß zumindest einer Ausführungsform sind zumindest zwei Öffnungen ausgebildet, die sich durch die n-leitende Schicht und die p-leitende Schicht hindurch zu einer Schicht der Metallschichtenfolge erstrecken. In einer der Öffnungen ist eine Anschlussfläche zur n-seitigen Kontaktierung des Halbleiterchips ausgebildet und in der anderen der Öffnungen ist eine Anschlussfläche zur p-seitigen Kontaktierung des Halbleiterchips ausgebildet. Mit anderen Worten wird der Halbleiterchip in dieser Ausführungsform durch zumindest zwei Öffnungen hindurch kontaktiert. Die Anschlussflächen unterscheiden sich durch ihre elektrische Verbindung mit unterschiedlich leitenden Bereichen des optoelektronischen Halbleiterchips.

Gemäß zumindest einer Ausführungsform grenzen Seitenflächen der Metallschichtenfolge, abgesehen von der oder den Öffnungen, zumindest mittelbar an eine Metallschicht, die elektrisch leitend mit n-leitendem Halbleitermaterial verbunden ist. Zumindest mittelbar bedeutet dabei, dass zwischen der Metallschichtenfolge und der Metallschicht, die elektrisch leitend mit dem n-leitenden Halbleitermaterial verbunden ist, eine elektrisch isolierende Isolierschicht angeordnet sein kann. Jedoch liegt diese Isolierschicht beispielsweise an den Kanten des optoelektronischen Halbleiterchips nicht frei, sondern sie ist umlaufend, also an allen Kanten des Halbleiterchips, von der Metallschicht umgeben, die elektrisch leitend mit dem n-leitenden Halbleitermaterial verbunden ist. Auf diese Weise ist die Metallschichtenfolge mit der Spiegelschicht umlaufend durch den metallischen n-Kontakt gekapselt, was zu einem mechanisch und chemisch besonders stabilen optoelektronischen Halbleiterchip führt. Lediglich im Bereich der Öffnungen ist die Spiegelschicht der Metallschichtenfolge nicht metallisch gekapselt, sondern beispielsweise von der oben genannten Passivierungsschicht bedeckt.

Gemäß zumindest einer Ausführungsform ist zumindest eine der Öffnungen, die sich von der n-leitenden Schicht bis zu einer Schicht der Metallschichtenfolge erstreckt, seitlich vollständig von der aktiven Zone des optoelektronischen Halbleiterchips umgeben. Vorzugsweise sind alle Öffnungen seitlich vollständig von der aktiven Zone umgeben. Das heißt, die Öffnung oder die Öffnungen, über die eine elektrische Kontaktierung des optoelektronischen Halbleiterchips erfolgt, sind im Fall eines strahlungsemittierenden optoelektronischen Halbleiterchips von leuchtender Fläche des optoelektronischen Halbleiterchips umgeben. Eine Verteilung des elektrischen Stroms zur Strahlungserzeugung in der aktiven Zone erfolgt vorzugsweise größtenteils oder vollständig unterhalb der aktiven Zone, sodass der optoelektronische Halbleiterchip eine besonders große Abstrahlfläche aufweist.

Gemäß zumindest einer Ausführungsform weist der Halbleiterchip einen ESD-Teilbereich auf, der Teile der Metallschichtenfolge, der p-leitenden Schicht und der n-leitenden Schicht umfasst, auf. Der ESD-Teilbereich ist dabei elektrisch antiparallel zum restlichen Halbleiterchip geschaltet. Das heißt, in dem Halbleiterchip ist durch Strukturierung der Metallschichtenfolge, der p-leitenden Schicht und der n-leitenden Schicht ein ESD-Teilbereich ausgebildet, der eine Diode bildet, die antiparallel zum restlichen Halbleiterchip geschaltet ist und damit als ESD-Schutzdiode für den restlichen Halbleiterchip wirkt. Bevorzugt ist der ESD-Teilbereich dabei seitlich vollständig von der aktiven Zone umgeben, sodass sich der ESD-Teilbereich innerhalb der leuchtenden Fläche im Falle eines strahlungsemittierenden optoelektronischen Halbleiterchips befindet. Im ESD-Teilbereich wird im Betrieb des optoelektronischen Halbleiterchips keine elektromagnetische Strahlung erzeugt, jedoch um den ESD-Teilbereich herum.

Gemäß zumindest einer Ausführungsform ist der Halbleiterchip in zumindest zwei aktive Teilbereiche unterteilt, die elektrisch in Reihe geschaltet sind. Mit anderen Worten umfasst der Halbleiterchip zumindest zwei Pixel, die aktiven Teilbereiche, die prinzipiell unabhängig voneinander betreibbar sind. Im optoelektronischen Halbleiterchip sind die Teilbereiche elektrisch in Reihe geschaltet, sodass der Halbleiterchip beispielsweise eine einzige n-Anschlussstelle und eine einzige p-Anschlussstelle aufweist.

Gemäß zumindest einer Ausführungsform ist zumindest eine elektrische Verbindung zwischen den aktiven Bereichen unterhalb der Strahlungsaustrittsfläche des Halbleiterchips angeordnet. Das heißt, die Verschaltung der aktiven Teilbereiche des Halbleiterchips in Reihe erfolgt nicht außerhalb des optoelektronischen Halbleiterchips oder oberhalb der Strahlungsaustrittsfläche, also im Strahlengang des optoelektronischen Halbleiterchips, sondern unterhalb der Strahlungsaustrittsfläche. Dabei sind vorzugsweise sämtliche elektrischen Verbindungen zwischen den aktiven Teilbereichen des Halbleiterchips unterhalb der Strahlungsaustrittsfläche angeordnet.

Gemäß zumindest einer Ausführungsform des optoelektronischen Halbleiterchips fallen im Betrieb des Halbleiterchips in jedem aktiven Teilbereich wenigstens 2 V Spannung ab. Vorzugsweise fallen an jedem aktiven Teilbereich wenigstens 3 V Spannung ab. Weist der Halbleiterchip zum Beispiel 28 aktive Teilbereiche auf, so wird der Halbleiterchip mit einer Spannung von zirka 90 V betrieben, wobei ein Strom von zirka 0,6 mA durch den Halbleiterchip fließen kann. Ein derartiger optoelektronischer Halbleiterchip mit mehreren aktiven Teilbereichen, die in Reihe zueinander geschaltet sind, kann nach Gleichrichtung und Glättung bei geeigneter Wahl der Anzahl der aktiven Teilbereiche auch mit handelsüblichem Wechselstrom betrieben werden. Ferner ist es möglich, dass der Halbleiterchip eine erste Gruppe von Pixel umfasst, die zueinander in Reihe geschaltet sind und eine zweite Gruppe von Pixel, die zueinander in Reihe geschaltet sind, wobei die erste und die zweite Gruppe antiparallel zueinander geschaltet sind. In diesem Fall ist es möglich, den Halbleiterchip ohne Gleichrichtung direkt mit Wechselstrom zu betreiben.

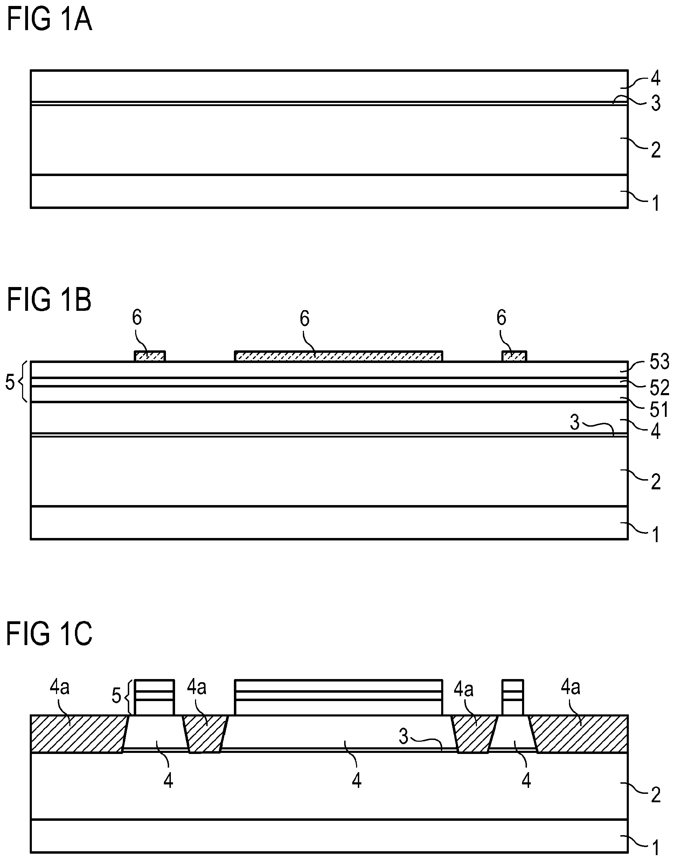

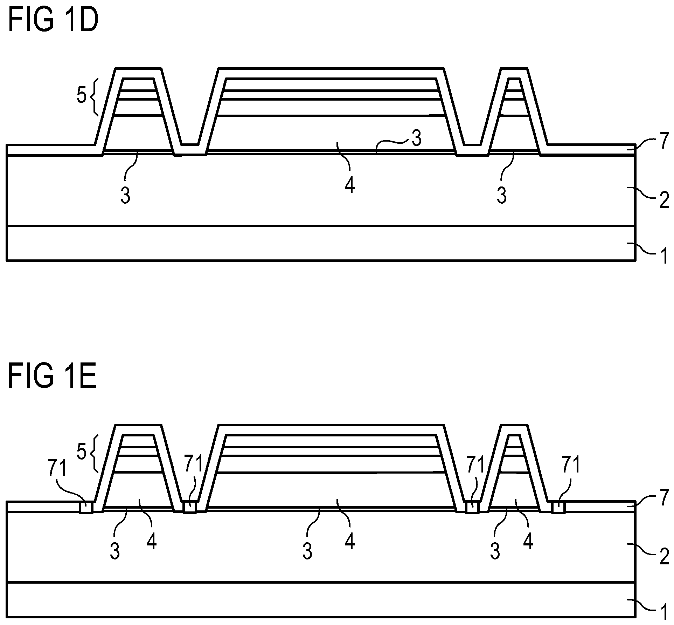

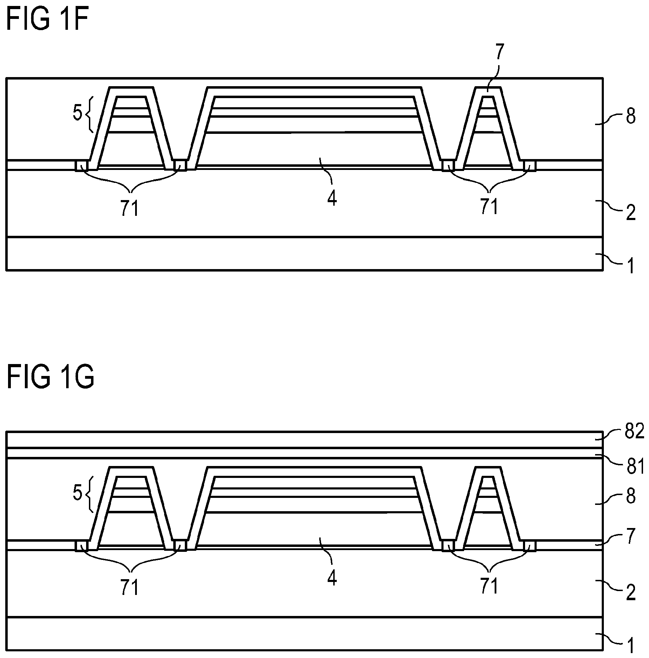

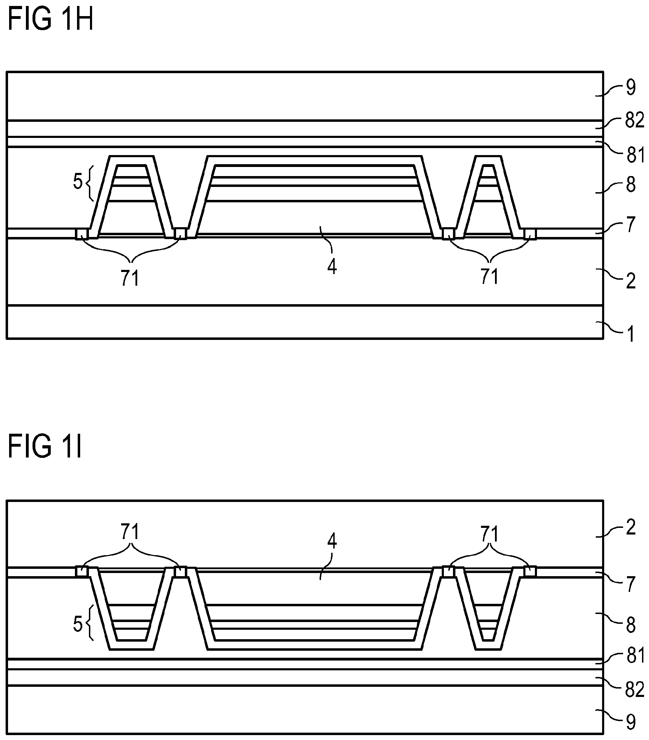

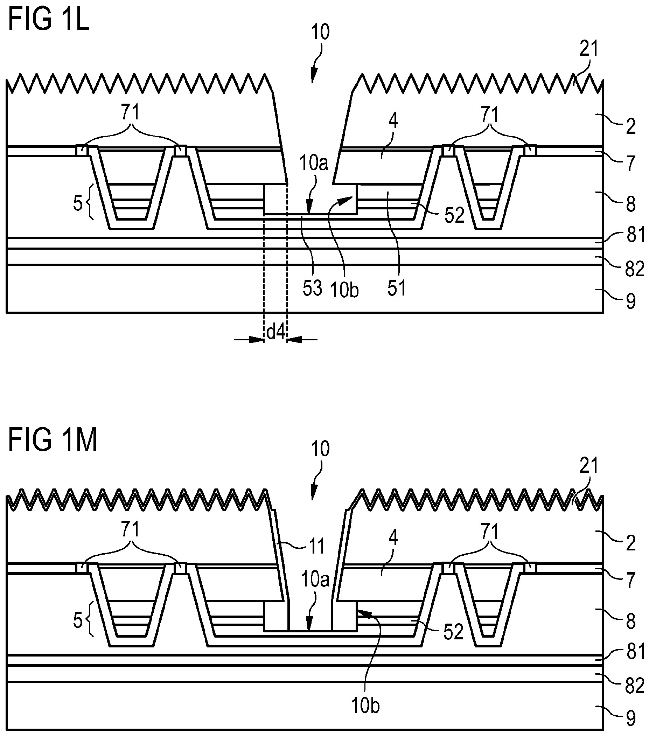

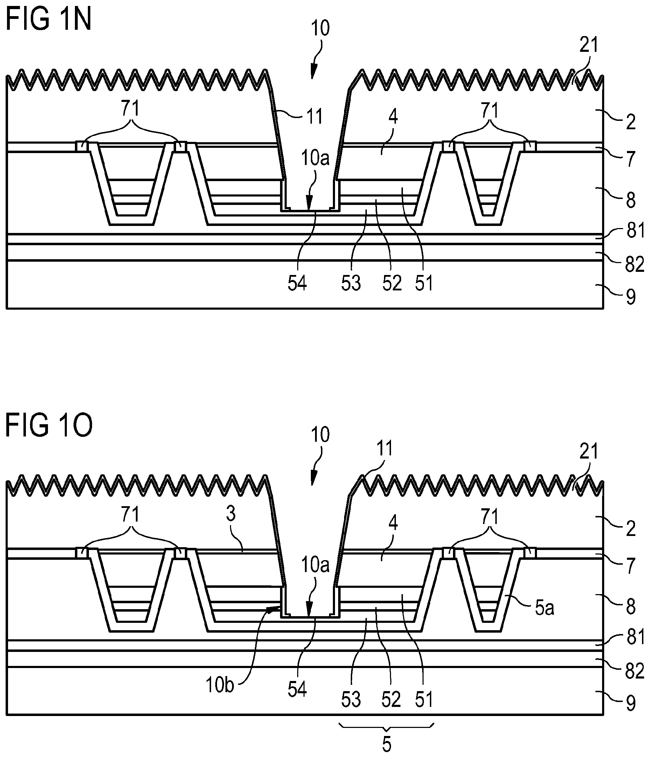

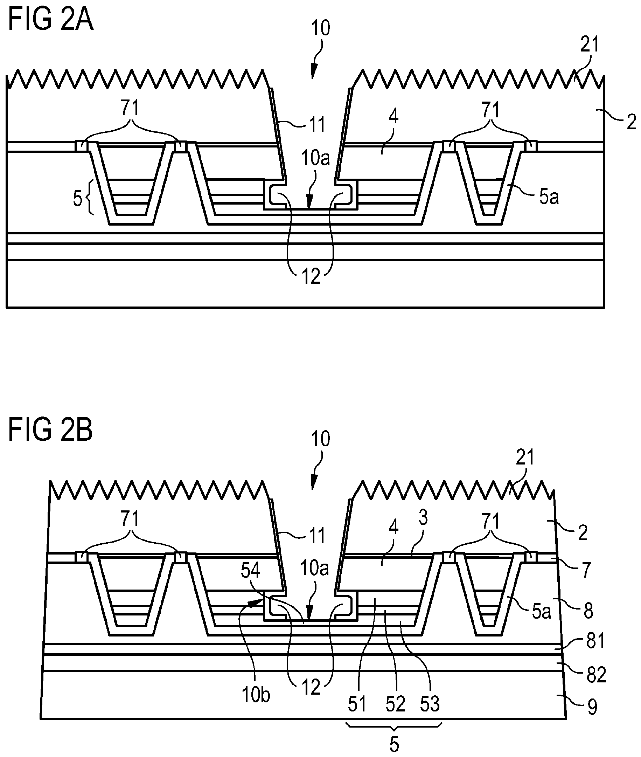

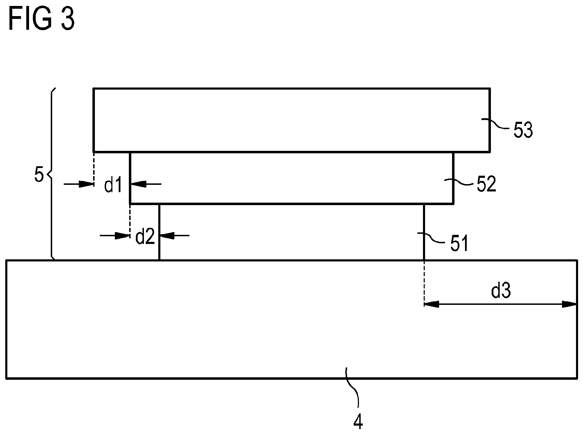

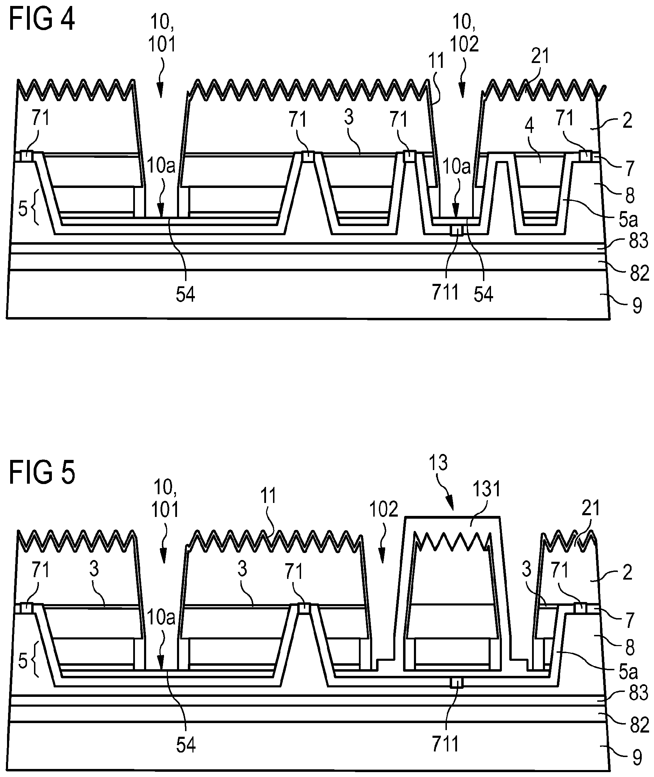

Im Folgenden werden das hier beschriebene Verfahren und der hier beschriebene optoelektronische Halbleiterchip anhand von Ausführungsbeispielen und den dazugehörigen Figuren näher erläutert.
- Anhand der: schematischen Schnittdarstellungen der Figuren 1A bis 1O ist ein erstes Ausführungsbeispiel eines hier beschriebenen Verfahrens näher erläutert.
- Anhand der: schematischen Schnittdarstellung der Figur 1O ist ein erstes Ausführungsbeispiel eines hier beschriebenen optoelektronischen Halbleiterchips näher erläutert.
- Anhand der: schematischen Schnittdarstellungen der Figuren 2A und 2B ist ein weiteres Ausführungsbeispiel eines hier beschriebenen Verfahrens näher erläutert.
- Anhand der: schematischen Schnittdarstellung der Figur 2B ist ein hier beschriebener optoelektronischer Halbleiterchip näher erläutert.
- Anhand der: schematischen Schnittdarstellung der Figur 3 ist ein Merkmal von hier beschriebenen optoelektronischen Halbleiterchips näher erläutert.
- Anhand der: schematischen Schnittdarstellungen der Figuren 4, 5, 6 sind weitere Ausführungsbeispiele des hier beschriebenen optoelektronischen Halbleiterchips näher erläutert.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

Anhand der schematischen Schnittdarstellungen der Figuren 1A bis 1O sind verschiedene Verfahrensschritte eines Ausführungsbeispiels eines Verfahrens zur Herstellung eines hier beschriebenen optoelektronischen Halbleiterchips näher erläutert. Die schematische Schnittdarstellung der Figur 1O zeigt dann den mittels des Verfahrens hergestellten optoelektronischen Halbleiterchip in einer ersten Ausführungsform.

Wie in der Figur 1A dargestellt, wird zunächst eine n-leitende Schicht 2 auf ein Aufwachssubstrat 1 aufgebracht, zum Beispiel epitaktisch abgeschieden. Das Aufwachssubstrat 1 ist beispielsweise aus Saphir gebildet. Bei der n-leitenden Schicht 2 handelt es sich beispielsweise um eine n-dotierte GaN-Schicht. Der n-leitenden Schicht 2 folgt eine p-leitende Schicht 4 nach. Bei der p-leitenden Schicht 4 handelt es sich beispielsweise um eine p-dotierte GaN-Schicht. An der Grenzfläche zwischen n-leitender Schicht 2 und p-leitender Schicht 4 ist eine aktive Zone 3 ausgebildet, die beispielsweise einen pn-Übergang, eine Einfach- oder eine Mehrfachquantentopfstruktur umfasst. Die aktive Schicht 3 ist vorzugsweise im Betrieb des herzustellenden optoelektronischen Halbleiterchips zur Emission von elektromagnetischer Strahlung aus dem Spektralbereich von sichtbarem Licht geeignet.

In einem nachfolgenden Verfahrensschritt wird die Metallschichtenfolge 5 auf die der n-leitenden Schicht 2 abgewandte Seite der p-leitenden Schicht 4 aufgebracht. Vorliegend umfasst die Metallschichtenfolge 5 eine Spiegelschicht 51, die beispielsweise aus Silber besteht. Ferner umfasst die Metallschichtenfolge 5 eine Sperrschicht 52, die zum Beispiel aus TiWN oder TiN oder ZnO besteht oder eines oder mehrere dieser Materialen enthält. Optional umfasst die Metallschichtenfolge 5 eine Verstärkungsschicht 53, die zumindest eines der folgenden Metalle enthält oder aus einem dieser Metalle besteht: Gold, Titan, Chrom. Die Verstärkungsschicht 53 dient dazu, im herzustellenden optoelektronischen Halbleiterchip eine ausreichende Stromaufweitung durch die Metallschichtenfolge 5 sicherzustellen.

Auf der der p-leitenden Schicht 4 abgewandten Oberseite der Metallschichtenfolge 5 wird nachfolgend eine Maske 6 ausgebildet, die beispielsweise mit einem Fotolack gebildet ist.

Wie aus der Figur 1C ersichtlich wird, wird mit Hilfe der Maske 6 anschließend eine Strukturierung der Metallschichtenfolge 5 sowie der p-leitenden Schicht 4 durchgeführt. Die Metallschichtenfolge 5 wird nasschemisch strukturiert oder mittels Rücksputtern.

Mit Hilfe derselben Fototechnik wie die Strukturierung der Metallschichtenfolge 5 erfolgt auch die Strukturierung der p-leitenden Schicht 4. Das heißt, die Maske 6 findet zur Strukturierung der Metallschichtenfolge 5 und der p-leitenden Schicht 4 Verwendung. Dadurch handelt es sich bei der Strukturierung der p-leitenden Schicht 4 um einen selbstjustierenden Prozess, für dessen Durchführung keine zusätzliche Maske definiert werden muss. Die Strukturierung der p-leitenden Schicht 4 erfolgt durch Neutralisierung der von der Metallschichtenfolge 5 freigelegten Bereiche 4a zu neutralisierten Bereichen. Alternativ, aber nicht erfindungsgemäß, kann die p-leitende Schicht 4 in den von der Metallschichtenfolge 5 freigelegten Bereichen auch entfernt werden. Die Neutralisierung oder die nicht erfindungsgemäße Entfernung erfolgt durch Rücksputtern mittels Argonionen oder Wasserstoffionen für eine Zeitdauer von beispielsweise weniger als zwei Minuten. Durch die Strukturierung der p-leitenden Schicht 4 bis zur n-leitenden Schicht 2 werden Kanten der p-leitenden Schicht 4 erzeugt, die in einem Winkel von 60° beispielsweise zur Ebene der Aufwachsfläche des Aufwachssubstrats 1 geneigt sind.

Anhand der schematischen Schnittdarstellung der Figur 3 ist ein Teil der strukturierten Metallschichtenfolge 5 mit angrenzender p-leitender Schicht 4 näher dargestellt. Durch die Strukturierung der Metallschichtenfolge 5 kann diese die Form einer umgedrehten Stufenpyramide aufweisen, wobei die Verstärkungsschicht 53 umlaufend um den Überstand d1 über die Sperrschicht 52 übersteht. Die Sperrschicht 52 steht seitlich, das heißt in lateraler Richtung, umlaufend über die Spiegelschicht 51 um den Betrag d2 über. Beispielsweise betragen die Überstande d1 und d2 jeweils höchstens 1 µm. Eine wie in der Figur 3 dargestellte Strukturierung der Metallschichtenfolge in eine umgedrehte Stufenpyramide erfolgt insbesondere bei einer nasschemischen Strukturierung der Metallschichtenfolge 5. Aufgrund der nachfolgenden Strukturierung der p-leitenden Schicht 4 mit derselben Fototechnik wie die Strukturierung der Metallschichtenfolge 5 steht die p-leitende Schicht 4 seitlich umlaufend um den Betrag d3 über die Spiegelschicht 51 über. Der Überstand dabei vorzugsweise höchstens 2 µm. Der Überstand ist dabei durch das in Verbindung mit den Figuren 1B und 1C beschriebene Herstellungsverfahren, das heißt die Strukturierung der Metallschichtenfolge 5 und der p-leitenden Schicht 4 mit derselben Maske 6, bedingt.

In einem nachfolgenden Verfahrensschritt wird eine Isolierschicht 7 an der dem Aufwachssubstrat 1 abgewandten Oberfläche aufgebracht. Die Isolierschicht 7 weist eine Dicke von höchstens 1 µm und bevorzugt von wenigstens 400 nm, zum Beispiel von 450 nm, auf und besteht beispielsweise aus Siliziumdioxid. Die Isolierschicht 7 wird beispielsweise mittels eines TEOS Precursors aufgebracht, der bei einem CVD-Prozess eingesetzt wird, um die Überformungseigenschaften zu verbessern. Die Isolierschicht 7 bedeckt die freigelegten Bereiche der n-leitenden Schicht sowie alle freiliegenden Außenflächen der p-leitenden Schicht, der aktiven Zone 3 sowie der Metallschichtenfolge 5 formschlüssig.

In dem in Verbindung mit Figur 1E beschriebenen Verfahrensschritt wird die Isolierschicht 7 durch die Erzeugung von Öffnungen 71 zur n-leitenden Schicht 2 hin geöffnet. Die Öffnungen können optional mit einem Metall wie beispielsweise Silber gefüllt werden, dies kann jedoch auch in einem nachfolgenden Verfahrensschritt beim Aufbringen der Metallschicht 8 erfolgen. Öffnungen 71 werden dabei zwischen den strukturierten Bereichen der p-leitenden Schicht 4 sowie außerhalb der strukturierten p-leitenden Bereiche 4 eingebracht. Die Öffnungen 71 in der Isolierschicht 7 sind beispielsweise ringförmig ausgebildet. Eine der Öffnungen 71 umschließt die aktive Zone 3 vollständig und kapselt diese nach Einbringen eines Metalls vollständig umlaufend metallisch. Zur Ausbildung der Öffnungen 71 wird eine Maske definiert, das heißt, es kommt eine weitere Fototechnik zum Einsatz.

In Verbindung mit der Figur 1F ist ein Verfahrensschritt beschrieben, bei dem die Metallschicht 8 beispielsweise durch Aufdampfen von Silber auf die dem Aufwachssubstrat 1 abgewandte Seite aufgebracht wird und dabei die dem Aufwachssubstrat 1 abgewandte Seite der n-leitenden Schicht vollständig abdeckt und die aktive Zone 3, die p-leitende Schicht und die metallische Schichtenfolge 5 vollständig einschließt. Sollte in den Öffnungen 71 noch kein Metall zur Kontaktierung der n-leitenden Schicht eingebracht sein, so dient die Metallschicht 8 in den Öffnungen 71 zur Kontaktierung der n-leitenden Schicht.

Nachfolgend werden eine Sperrschicht 81 und eine Verstärkungsschicht 82 auf die dem Aufwachssubstrat 1 abgewandte Seite der Metallschicht 8 aufgebracht. Beispielsweise wird auf diese Weise folgende Schichtenfolge erzeugt: Ti/TiWN/TiN/TiPtAu. Die Verstärkungsschicht 82 enthält dabei vorzugsweise Gold.

Nachfolgend wird auf die dem Aufwachssubstrat 1 abgewandte Seite der Verstärkungsschicht 82 der Träger 9 aufgebracht. Der Träger 9 kann aufgebondet werden, ferner ist es möglich, dass der Träger 9 durch einen galvanischen Prozess erzeugt wird. Der Träger 9 ist vorliegend elektrisch leitend ausgebildet. Der Träger 9 kann beispielsweise mit einem der folgenden Materialien gebildet sein oder aus einem der folgenden Materialien bestehen: Germanium, Silizium, Kupfer, Nickel.

Im nachfolgenden Verfahrensschritt beschrieben in Verbindung mit der Figur 1I wird das Aufwachssubstrat 1 durch ein Laserablöseverfahren oder chemo-mechanisch von der n-leitenden Schicht abgelöst.

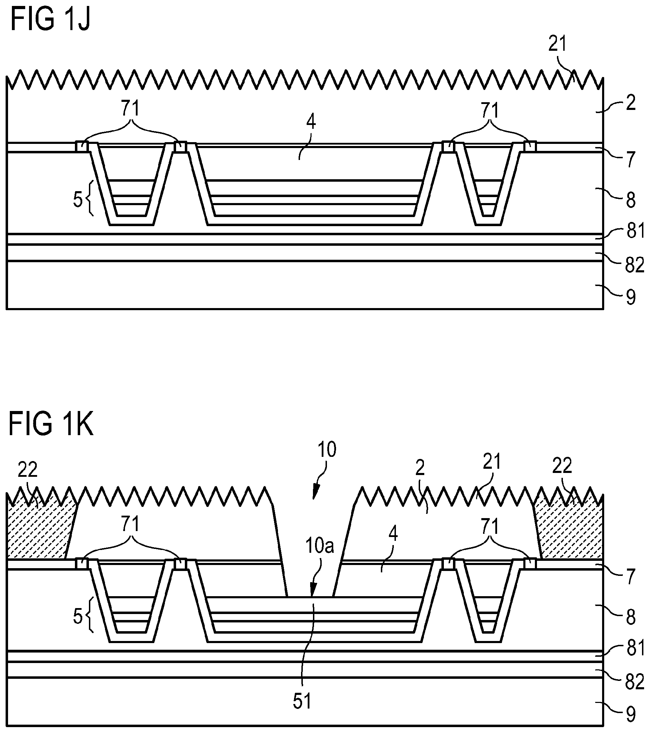

In einem weiteren Verfahrensschritt, siehe dazu Figur 1J, kann die dem Träger 9 abgewandte Oberfläche der n-leitenden Schicht 21 aufgeraut werden. Das heißt, an der Strahlungsaustrittsfläche 21 befinden sich dann Aufrauungen, welche eine Wahrscheinlichkeit für Totalreflexion von elektromagnetischer Strahlung beim Durchtritt durch die Strahlungsaustrittsfläche reduzieren.

Im in Verbindung mit der Figur 1K beschriebenen Verfahrensschritt wird eine Öffnung 10 erzeugt, die sich durch die n-leitende Schicht 2 und die p-leitende Schicht 4 zur Spiegelschicht 51 der Metallschichtenfolge 5 hin erstreckt. Optional kann eine Mesa-Ätzung erfolgen, wobei die Bereiche 22 entfernt werden. Die Mesa-Ätzung sowie die Erzeugung der Öffnung 10 erfolgen mittels einer nicht gezeigten Maske, das heißt unter Verwendung einer Fototechnik. Zur Strukturierung findet beispielsweise heiße Phosphorsäure Verwendung, die auf der Isolierschicht 7 aus Siliziumdioxid und der Spiegelschicht 51 aus Silber stoppt. Auch der Einsatz alternativer Chemikalien zur Strukturierung ist möglich.

In einem weiteren Verfahrensschritt wird die Spiegelschicht 51 und gegebenenfalls die Sperrschicht 52 an der Bodenfläche 10a der Öffnung 10 entfernt. Das Entfernen erfolgt beispielsweise durch Ätzen, wobei als Maske die die Öffnung umgebenden Halbleiterschichten, also die n-leitende Schicht 2 und die p-leitende Schicht 4 sowie die aktive Zone 3, Verwendung finden. Durch das Entfernen der Spiegelschicht 51 und gegebenenfalls der Sperrschicht 52 wird ein Überstand erzeugt, in dem die p-leitende Schicht 4 umlaufend über die Spiegelschicht 1 übersteht. Der Überstand beträgt d4 ≤ 4 µm, zum Beispiel d4 = 1 µm.

An der Bodenfläche 10a der Öffnung 10 ist die Verstärkungsschicht 53 freigelegt, die beispielsweise aus Gold besteht oder Gold enthält.

In einem nachfolgenden Verfahrensschritt, Figur 1M, wird die Passivierungsschicht 11 mittels eines ALD-Prozesses auf die dem Träger 9 abgewandte Außenfläche aufgebracht. Die Passivierungsschicht 11 kann beispielsweise eines der folgenden Materialien enthalten oder aus einem der folgenden Materialien bestehen: einem Aluminiumoxid, einem Zinkoxid, einem Titanoxid, einem Siliziumoxid.

Dabei ist es möglich, dass die Passivierungsschicht 11 den Hohlraum, welche durch den Überstand der p-leitenden Schicht 4 über die Spiegelschicht 52 erzeugt ist, vollständig ausfüllt. Nach dem Abschluss der Abscheidung der Passivierungsschicht 11 ist auch die Bodenfläche 10a der Öffnung 10 mit dem Material der Passivierungsschicht 11 bedeckt.

In einem nachfolgenden Verfahrensschritt (vergleiche Figur 1N), bei dem beispielsweise eine Fototechnik unter Verwendung einer Maske eingesetzt wird, wird die Verstärkungsschicht 53 an der Bodenfläche 10a der Öffnung 10 wieder freigelegt, sodass eine Anschlussfläche 54 entsteht, an der nachfolgend ein Kontaktdraht (auch: Bonddraht) befestigt werden kann.

Im abschließenden Verfahrensschritt, beschrieben in Verbindung mit Figur 1O, wird in einzelne optoelektronische Halbleiterchips vereinzelt. Wie aus der Figur 1O ersichtlich ist, umfasst der optoelektronische Halbleiterchip einen Träger 9, der elektrisch leitend ausgebildet ist. Dem Träger 9 folgt eine Verstärkungsschicht 82 nach, auf die eine Sperrschicht 81 zur Metallschicht 8 hin ausgebildet ist. Die Metallschicht 9 ist durch die Öffnungen 71 hindurch elektrisch leitend mit dem n-leitenden Bereich 2 des optoelektronischen Halbleiterchips verbunden. Das heißt, die Metallschicht 8 dient zur n-seitigen Kontaktierung des optoelektronischen Halbleiterchips. Die Metallschicht 8 umgibt dabei, abgesehen von der Öffnung 10, die Metallschichtenfolge 5 mit der Spiegelschicht 51 seitlich umlaufend, sodass die Spiegelschicht 51 zumindest mittelbar umlaufend durch die Metallschicht 8 metallisch gekapselt ist. Zwischen der Metallschicht 8 und der Metallschichtenfolge 5 sowie der p-leitenden Schicht 4 ist die Isolierschicht 7 eingebracht, welche die Metallschicht 8 elektrisch von der p-leitenden Schicht 4 entkoppelt. Die p-leitende Schicht 4 ist über die Verstärkungsschicht 53 der Metallschichtenfolge 5 elektrisch kontaktierbar. In der Öffnung 10, in der die Verstärkungsschicht 53 zur elektrischen Kontaktierung der p-leitenden Schicht 4 zugänglich ist, ist die Spiegelschicht 1 mittels der Passivierungsschicht 11 an den Seitenflächen 1b der Öffnung 10 vollständig bedeckt und gekapselt.

Insgesamt kann der in Verbindung mit Figur 1O beschriebene optoelektronische Halbleiterchip durch nur vier Fototechniken hergestellt werden (vergleich dazu die Beschreibung der Figuren 1B, 1E, 1K und 1N).

In Verbindung mit den Figuren 2A und 2B ist anhand schematischer Schnittdarstellungen ein weiteres Ausführungsbeispiel eines hier beschriebenen Verfahrens näher erläutert, bei dem auf die in Verbindung mit der Figur 1N beschriebene Fototechnik zur Öffnung der Passivierungsschicht 11 über der Verstärkungsschicht 53 der Metallschichtenfolge 5 verzichtet werden kann. Wie aus der Figur 2A ersichtlich ist, wird dabei ein Plasma-unterstütztes Ätzen ohne vorherige Definition einer Maske nach dem Verfahrensschritt 1M vollflächig durchgeführt. Dadurch wird die Passivierungsschicht 11 an der dem Träger 9 abgewandten Oberseite der n-leitenden Schicht 2, das heißt der Strahlungsdurchtrittsfläche 21, entfernt. Da die Passivierungsschicht 11 im Bereich des Überstands der p-leitenden Schicht in der Öffnung 10 über der Spiegelschicht 52 dicker ist als in anderen Bereichen des Halbleiterkörpers, bleibt dort die Passivierungsschicht 11 vorhanden, sodass eine ausreichende Verkapselung der Spiegelschicht 52 an den Seitenflächen 10b der Öffnung 10 gewährleistet ist. Die Figur 2B zeigt dabei den vereinzelten optoelektronischen Halbleiterchip in einer schematischen Schnittdarstellung.

In Verbindung mit der schematischen Schnittdarstellung der Figur 4 ist ein weiteres Ausführungsbeispiel eines hier beschriebenen optoelektronischen Halbleiterchips näher erläutert. Im Unterschied zum in Verbindung mit der Figur 1O beschriebenen optoelektronischen Halbleiterchip findet die n-seitige Kontaktierung des optoelektronischen Halbleiterchips hier nicht über den Träger 9 statt. Der Träger 9 kann daher auch mit einem elektrisch isolierenden Material gebildet sein. Alternativ oder zusätzlich kann eine Isolierschicht 83, die beispielsweise aus Siliziumdioxid besteht, zwischen dem Träger 9 und der Metallschicht 8 angeordnet sein.

Die elektrische Kontaktierung des optoelektronischen Halbleiterchips erfolgt im Ausführungsbeispiel der Figur 4 durch zwei Öffnungen 10. Mittels der Öffnung 101 wird der optoelektronische Halbleiterchip p-seitig kontaktiert. Als Anschlussfläche 54 dient wiederum die Verstärkungsschicht 53 der Metallschichtenfolge 5.

Die n-seitige Kontaktierung des optoelektronischen Halbleiterchips erfolgt über die Öffnung 102. Dazu ist im Bereich der Öffnung 102 zwischen der Metallschichtenfolge 5, das heißt der Verstärkungsschicht 53, und der Metallschicht 8 eine zusätzliche Öffnung 711 ausgebildet, in der die Isolierschicht 7 durchbrochen ist. Diese Öffnung kann beispielsweise im in Verbindung mit der Figur 1E beschriebenen Verfahrensschritt in der Passivierungsschicht 7, das heißt bei der Definition der zweiten im Verfahren benötigten Maske, erzeugt werden. Der in Verbindung mit Figur 4 beschriebene optoelektronische Halbleiterchip kann durch die beiden Öffnungen 101, 102 hindurch jeweils mittels eines Anschlussdrahts elektrisch leitend kontaktiert werden.

In dem in Verbindung mit der Figur 5 beschriebenen Ausführungsbeispiel eines hier beschriebenen optoelektronischen Halbleiterchips ist der optoelektronische Halbleiterchip wie auch beim Ausführungsbeispiel der Figur 1O durch den Träger 9 hindurch n-seitig kontaktiert. Der optoelektronische Halbleiterchip umfasst in diesem Ausführungsbeispiel jedoch zusätzlich einen ESD-Teilbereich 13, der in einem durch die Öffnung 102 umlaufend abgetrennten Teilbereich von n-leitender Schicht 2, aktiver Zone 3 und p-leitender Halbleiterschicht 4 sowie Metallschichtenfolge 5 ausgebildet ist. Mittels der Metallisierung 131, die elektrisch leitend mit der an der Bodenfläche der Öffnung 102 freigelegten Verstärkungsschicht 53 der Metallschichtenfolge 5 verbunden ist, sowie der Öffnung 711 in der Isolierschicht 7 ist der ESD-Teilbereich antiparallel zu den verbleibenden Bereichen des optoelektronischen Halbleiterchips verschaltet. Auf diese Weise bildet der ESD-Teilbereich 13 eine ESD-Schutzdiode für den optoelektronischen Halbleiterchip aus, die umlaufend von der strahlungsemittierenden aktiven Zone 3 umgeben ist. Dabei ist auch der n-Kontakt 71 wie die Öffnung 102 umlaufend ausgestaltet, um einen Kurzschluss zu vermeiden. Für den optoelektronischen Halbleiterchip gemäß dem Ausführungsbeispiel der Figur 5 ist wenigstens eine weitere Fototechnik notwendig, die zur Strukturierung der Metallisierung 131 benötigt wird.

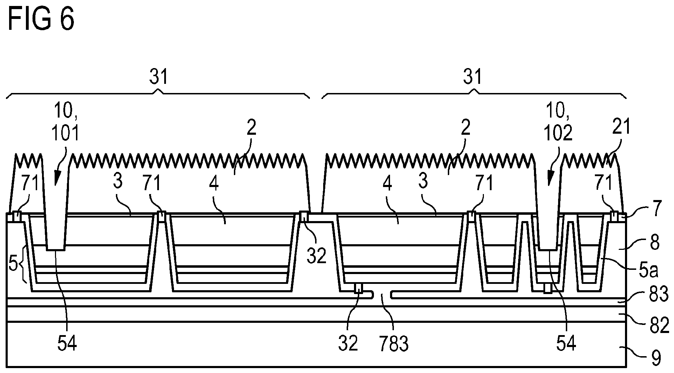

In Verbindung mit Figur 6 ist ein weiteres Ausführungsbeispiel eines hier beschriebenen optoelektronischen Halbleiterchips näher erläutert. In diesem Ausführungsbeispiel ist der optoelektronische Halbleiterchip in mehrere aktive Teilbereiche 31 unterteilt. Das heißt, die gemeinsam epitaktisch gewachsenen Schichten sind in mehrere in lateraler Richtung separierte Teilbereiche unterteilt. In der Figur 6 sind zwei aktive Teilbereiche 31 dargestellt, welche zwei Pixel des optoelektronischen Halbleiterchips bilden. Die aktiven Teilbereiche 31 sind dabei durch die elektrischen Verbindungen 32 miteinander in Reihe geschaltet, wobei die Metallschicht 8 zur n-seitigen Kontaktierung des optoelektronischen Halbleiterchips durch die Isolierung 783 zwischen benachbarten Teilbereichen 31 jeweils unterbrochen ist. Bei dem optoelektronischen Halbleiterchip handelt es sich um einen wie in Verbindung mit Figur 4 beschriebenen optoelektronischen Halbleiterchip, bei dem die n-seitige Kontaktierung des Chips nicht durch den Träger 9, sondern durch Anschlussflächen 54 in den Öffnungen 101 und 102 erfolgt. Die Erzeugung der für die elektrischen Verbindungen 32 notwendigen Öffnungen in der Isolierschicht 7 sowie die Erzeugung einer Öffnung zur Bildung der Isolierung 783 in der Metallschicht 8 erfolgt beispielsweise zusammen mit im in Verbindung mit Figur 1E beschriebenen Öffnen der Isolierschicht 7, das heißt während der zweiten Fototechnik. An den Teilbereichen 31 fällt im Betrieb des optoelektronischen Halbleiterchips beispielsweise eine Spannung von je wenigstens 2 V ab. Auf diese Weise kann durch das in Reihe Schalten mehrerer aktiver Teilbereiche 31 ein optoelektronischer Halbleiterchip erzeugt werden, der mit Spannungen von 90 V oder mehr betrieben werden kann. Insgesamt sind hier Verfahren zur Herstellung von optoelektronischen Halbleiterchips beschrieben, mit denen optoelektronische Halbleiterchips aufgrund einer geringen Anzahl von Fototechniken besonders kostengünstig hergestellt werden können. Die optoelektronischen Halbleiterchips zeichnen sich neben ihrer einfachen Herstellbarkeit beispielsweise durch eine umlaufende metallische Verkapselung der Spiegelschicht 52 und damit einer hohen mechanischen und chemischen Stabilität aus.

## Patentansprüche

1. Verfahren zur Herstellung eines optoelektronischen Halbleiterchips mit den Schritten:
- Bereitstellen einer n-leitenden Schicht (2),
- Anordnen einer p-leitenden Schicht (4) auf der n-leitenden Schicht (2),
- Anordnen einer Metallschichtenfolge (5) auf der p-leitenden Schicht (4), wobei
- die Metallschichtenfolge (5) zumindest eine Spiegelschicht (51) und eine Sperrschicht (52) umfasst, und
- die Spiegelschicht (51) der Metallschichtenfolge (5) der p-leitenden Schicht (4) zugewandt ist,
- Anordnen einer Maske (6) an der der p-leitenden Schicht (4) abgewandten Seite der Metallschichtenfolge (5), und
- stellenweises Abtragen der Metallschichtenfolge (5) und Freilegen der p-leitenden Schicht (4) unter Verwendung der Maske (6),
**dadurch gekennzeichnet, dass** das Verfahren weiterhin umfasst:
- stellenweises Neutralisieren der freigelegten Bereiche (4a) der p-leitenden Schicht (4) bis zur n-leitenden Schicht (2) unter Verwendung der Maske (6), indem ein p-Dotierstoff in der p-leitenden Schicht (4) neutralisiert wird, sodass die neutralisierten Bereiche (4a) der p-leitenden Schicht (4) zunächst elektrisch isoliert werden und die neutralisierten Bereiche (4a) der p-leitenden Schicht anschließend zumindest stellenweise n-leitend dotiert werden, wodurch die n-leitende Schicht (2) durch die neutralisierten Bereiche (4a) der p-leitenden Schicht (4) hindurch elektrisch kontaktierbar ist.

2. Optoelektronischer Halbleiterchip mit
- einer Metallschichtenfolge (5), die zumindest eine Spiegelschicht (51) und eine Sperrschicht (52) umfasst,
- einer n-leitenden Schicht (2), und
- einer p-leitenden Schicht (4), wobei die Spiegelschicht (51) der Metallschichtenfolge (5) der p-leitenden Schicht (4) zugewandt ist,
**dadurch gekennzeichnet, dass**
- die p-leitende Schicht (4) stellenweise bis zur n-leitenden Schicht (2) neutralisiert ist, indem ein p-Dotierstoff in neutralisierten Bereichen (4a) der p-leitenden Schicht (4) neutralisiert ist, und
- die neutralisierten Bereiche (4a) der p-leitenden Schicht (4) stellenweise n-leitend dotiert sind, wodurch die n-leitende Schicht (2) durch die neutralisierten Bereiche (4a) der p-leitenden Schicht (4) hindurch elektrisch kontaktierbar ist.

3. Optoelektronischer Halbleiterchip oder Verfahren nach dem vorherigen Anspruch, wobei
- eine Öffnung (10) ausgebildet ist, die sich durch die n-leitende Schicht (2) und die p-leitende Schicht (4) erstreckt,
- an einer Bodenfläche (10a) der Öffnung (10) eine Schicht der Metallschichtenfolge (5) freigelegt ist, und
- eine Anschlussfläche (54) zur elektrischen Kontaktierung des Halbeiterchips an der Bodenfläche (10a) ausgebildet ist.

4. Optoelektronischer Halbleiterchip oder Verfahren nach dem vorherigen Anspruch, wobei
- sich die Öffnung (10) zumindest teilweise durch die Spiegelschicht (51) der Metallschichtenfolge (5) erstreckt, und
- eine Seitenfläche (10b) der Öffnung (10) zumindest im Bereich der Spiegelschicht (51) vollständig von einer Passivierungsschicht (11) bedeckt ist.

5. Optoelektronischer Halbleiterchip oder Verfahren nach einem der vorherigen Ansprüche, wobei
- die p-leitende Schicht (4) die Spiegelschicht (51) in der Öffnung (10) seitlich überragt.

6. Optoelektronischer Halbleiterchip oder Verfahren nach dem vorherigen Anspruch, wobei
- die Seitenfläche (10b) der Öffnung (10) im Bereich der Spiegelschicht (51) einen anderen Winkel mit der der Spiegelschicht (15) zugewandten Oberfläche eines Trägers (9) des Halbleiterchips einschließt als die Seitenfläche (10b) der Öffnung (10) im Bereich der p-leitenden Schicht (4).

7. Optoelektronischer Halbleiterchip oder Verfahren nach einem der Ansprüche 4 bis 6, wobei
- die Passivierungsschicht (11) mittels eines ALD-Prozesses erzeugt ist.

8. Optoelektronischer Halbleiterchip oder Verfahren nach einem der Ansprüche 3 bis 7, wobei
- zumindest zwei Öffnungen (101, 102) ausgebildet sind,
- in einer der Öffnungen (102) eine Anschlussfläche zur n-seitigen Kontaktierung des Halbleiterchips ausgebildet ist und
- in einer anderen der Öffnungen (101) eine Anschlussfläche zur p-seitigen Kontaktierung des Halbleiterchips ausgebildet ist.

9. Optoelektronischer Halbleiterchip oder Verfahren nach einem der Ansprüche 3 bis 7, wobei
- Seitenflächen (5a) der Metallschichtenfolge (5) abgesehen von den Öffnungen (10, 101, 102) zumindest mittelbar an eine Metallschicht (8) grenzen, die elektrisch leitend mit dem n-leitenden Halbeitermaterial (2) verbunden ist.

10. Optoelektronischer Halbleiterchip oder Verfahren nach einem der Ansprüche 3 bis 9, wobei
- zumindest eine Öffnung (10, 101, 102) seitlich vollständig von einer aktiven Zone (3) umgeben ist.

11. Optoelektronischer Halbleiterchip oder Verfahren nach einem der Ansprüche 3 bis 9, wobei
- ein ESD-Teilbereich (13) des Halbleiterchips, der Teile der Metallschichtenfolge (5), der p-leitenden Schicht (4) und der n-leitenden Schicht (2) umfasst, elektrisch antiparallel zum restlichen Halbleiterchip geschaltet ist, und
- der ESD-Teilbereich (13) eine ESD-Schutzdiode für den restlichen Halbleiterchip bildet.

12. Optoelektronischer Halbleiterchip oder Verfahren nach dem vorherigen Anspruch, wobei
- der ESD-Teilbereich (13) seitlich vollständig von der aktiven Zone (3) umgeben ist.

13. Optoelektronischer Halbleiterchip oder Verfahren nach einem der vorhergehenden Ansprüche, wobei die p-leitende Schicht (4) die Spiegelschicht (51) seitlich überragt und ein seitlicher Überstand (d3) der p-leitenden Schicht (4) über die Spiegelschicht (51) höchstens 5 µm beträgt.

14. Optoelektronischer Halbleiterchip nach einem der Ansprüche 2 bis 13, wobei
- der Halbleiterchip in zumindest zwei aktive Teilbereiche (31) unterteilt ist, die elektrisch in Reihe geschaltet sind.

15. Optoelektronischer Halbleiterchip nach dem vorherigen Anspruch, wobei
- eine elektrische Verbindung (32) zwischen den aktiven Teilbereichen (31) unterhalb der Strahlungsaustrittsfläche (22) des Halbleiterchips angeordnet ist.

## Claims

1. A method for producing an optoelectronic semiconductor chip comprising the following steps:
- providing an n-conducting layer (2),
- arranging a p-conducting layer (4) on the n-conducting layer (2),
- arranging a metal layer sequence (5) on the p-conducting layer (4), wherein
- the metal layer sequence (5) comprises at least one mirror layer (51) and a barrier layer (52), and
- the mirror layer (51) of the metal layer sequence (5) faces the p-conducting layer (4),
- arranging a mask (6) at that side of the metal layer sequence (5) which is remote from the p-conducting layer (4), and
- in places removing the metal layer sequence (5) and uncovering the p-conducting layer (4) using the mask (6),
**characterized in that** the method further comprises:
- in places neutralizing the uncovered regions (4a) of the p-conducting layer (4) as far as the n-conducting layer (2) using the mask (6), wherein a p-type dopant in the p-conducting layer (4) is neutralized, such that the neutralized regions (4a) of the p-conducting layer (4) are first electrically insulated and the neutralized regions (4a) of the p-conducting layer are then doped in n-conducting fashion at least in places, such that the n-conducting layer (2) is electrically connectable throughout the neutralized regions (4a) of the p-conducting layer (4).

2. An optoelectronic semiconductor chip comprising:
- a metal layer sequence (5), which comprises at least one mirror layer (51) and a barrier layer (52),
- a n-conducting layer (2), and
- a p-conducting layer (4), wherein
- the mirror layer (51) of the metal layer sequence (5) faces the p-conducting layer (4),
**characterized in that**
- the p-conducting layer (4) is neutralized in places as far as the n-conducting layer (2), wherein a p-type dopant is neutralized in neutralized regions (4a) of the p-conducting layer (4), and
- the neutralized regions (4a) of the p-conducting layer (4) are doped in n-conducting fashion in places, such that the n-conducting layer (2) is electrically connectable throughout the neutralized regions (4a) of the p-conducting layer (4).

3. Optoelectronic semiconductor chip or method according to the preceding claim, wherein
- an opening (10) is formed which extends through the n-conducting layer (2) and the p-conducting layer (4),
- a layer of the metal layer sequence (5) is uncovered at a bottom area (10a) of the opening (10), and
- a connection pad (54) for making electrical contact with the semiconductor chip is formed at the bottom area (10a).

4. Optoelectronic semiconductor chip or method according to the preceding claim, wherein
- the opening (10) at least partly extends through the mirror layer (51) of the metal layer sequence (5), and
- a side area (10b) of the opening (10) is completely covered by a passivation layer (11) at least in the region of the mirror layer (51).

5. Optoelectronic semiconductor chip or method according to any of the preceding claims, wherein
- the p-conducting layer (4) laterally projects beyond the mirror layer (51) in the opening (10).

6. Optoelectronic semiconductor chip or method according to the preceding claim, wherein
the side area (10b) of the opening (10) in the region of the mirror layer (51) forms, with that surface of a carrier (9) of the semiconductor chip which faces the mirror layer (51), a different angle from the side area (10b) of the opening (10) in the region of the p-conducting layer (4).

7. Optoelectronic semiconductor chip or method according to any of claims 4 through 6, wherein
the passivation layer (11) is produced by means of an ALD process.

8. Optoelectronic semiconductor chip or method according to any of claims 3 through 7, wherein
- at least two openings (101, 102) are formed,
- a connection pad for making contact with the semiconductor chip on the n-side is formed in one of the openings (102), and
- a connection pad for making contact with the semiconductor chip on the p-side is formed in another of the openings (101).

9. Optoelectronic semiconductor chip or method according to any of claims 3 through 7, wherein
side areas (5a) of the metal layer sequence (5) apart from the openings (10, 101, 102) at least indirectly adjoin a metal layer (8) that is electrically conductively connected to the n-conducting semiconductor material (2).

10. Optoelectronic semiconductor chip or method according to any of claims 3 through 9, wherein
at least one opening (10, 101, 102) is laterally completely surrounded by an active zone (3).

11. Optoelectronic semiconductor chip or method according to any of claims 3 through 9, wherein
- an ESD partial region (13) of the semiconductor chip, which comprises parts of the metal layer sequence (5), of the p-conducting layer (4) and of the n-conducting layer (2), is electrically connected in antiparallel with the rest of the semiconductor chip, and
- the ESD partial region (13) forms an ESD protective diode for the rest of the semiconductor chip.

12. Optoelectronic semiconductor chip or method according to the preceding claim, wherein
the ESD partial region (13) is laterally completely surrounded by the active zone (3).

13. Optoelectronic semiconductor chip or method according to any of the preceding claims, wherein the p-conducting layer (4) laterally projects beyond the mirror layer (51), and the lateral overhang (d3) of the p-conducting layer (4) beyond the mirror layer (51) is at most 5 µm.

14. Optoelectronic semiconductor chip according to any of claims 2 through 13, wherein
the semiconductor chip is subdivided into at least two active partial regions (31) which are electrically connected in series.

15. Optoelectronic semiconductor chip according to the preceding claim, wherein
an electrical connection (32) between the active partial regions (31) is arranged below the radiation exit area (22) of the semiconductor chip.

## Revendications

1. Procédé de fabrication d'une puce en semiconducteur optoélectronique, comprenant les étapes suivantes:
- production d'une couche à conduction n (2),
- disposition d'une couche à conduction p (4) sur la couche à conduction n (2),
- disposition d'une séquence de couches métalliques (5) sur la couche à conduction p (4),
- la séquence de couches métalliques (5) comprenant au moins une couche réfléchissante (51) et une couche de blocage (52), et
- la couche réfléchissante (51) de la séquence de couches métalliques (5) faisant face à la couche à conduction p (4),
- disposition d'un masque (6) sur le côté de la séquence de couches métalliques (5) à l'opposé de la couche à conduction p (4), et
- enlèvement par endroits de la séquence de couches métalliques (5) et libération de la couche à conduction p (4) en utilisant le masque (6),
**caractérisé en ce que** le procédé comprend en outre:
- neutralisation par endroits des zones libérées (4a) de la couche à conduction p (4) jusqu'à la couche à conduction n (2) en utilisant le masque (6), **en ce qu'**un agent de dopage p dans la couche à conduction p (4) est neutralisé, de sorte que les zones neutralisées (4a) de la couche à conduction p (4) sont tout d'abord isolées électriquement et les zones neutralisées (4a) de la couche à conduction p sont ensuite dopées en conduction n au moins par endroits, ce qui a pour effet que le contact électrique avec la couche à conduction n (2) peut être établi à travers les zones neutralisées (4a) de la couche à conduction p (4).

2. Puce en semiconducteur optoélectronique, comprenant:
- une séquence de couches métalliques (5) qui comprend au moins une couche réfléchissante (51) et une couche de blocage (52),
- une couche à conduction n (2), et
- une couche à conduction p (4), la couche réfléchissante (51) de la séquence de couches métalliques (5) faisant face à la couche à conduction p (4),
**caractérisée en ce que**
- la couche à conduction p (4) est neutralisée par endroits jusqu'à la couche à conduction n (2) **en ce qu'**un agent de dopage p dans zones neutralisées (4a) de la couche à conduction p (4) est neutralisé, et
- les zones neutralisées (4a) de la couche à conduction p (4) sont dopées en conduction n par endroits, ce qui a pour effet que le contact électrique avec la couche à conduction n (2) peut être établi à travers les zones neutralisées (4a) de la couche à conduction p (4).

3. Puce en semiconducteur optoélectronique ou procédé selon la revendication précédente,
- une ouverture (10) étant formée, laquelle s'étend à travers la couche à conduction n (2) et la couche à conduction p (4),
- une couche de la séquence de couches métalliques (5) étant libérée sur une surface de fond (10a) de l'ouverture (10), et
- une surface de raccordement (54) destinée à l'établissement du contact électrique avec la puce en semiconducteur est formée sur la surface de fond (10a).

4. Puce en semiconducteur optoélectronique ou procédé selon la revendication précédente,
- l'ouverture (10) s'étend au moins partiellement à travers la couche réfléchissante (51) de la séquence de couches métalliques (5), et
- une surface latérale (10b) de l'ouverture (10) est entièrement recouverte par une couche de passivation (11) au moins dans la zone de la couche réfléchissante (51).

5. Puce en semiconducteur optoélectronique ou procédé selon l'une des revendications précédentes,
la couche à conduction p (4) dépasse latéralement de la couche réfléchissante (51) dans l'ouverture (10).

6. Puce en semiconducteur optoélectronique ou procédé selon la revendication précédente,
la surface latérale (10b) de l'ouverture (10) forme dans la zone de la couche réfléchissante (51), avec la surface d'un support (9) de la puce en semiconducteur qui fait face à la couche réfléchissante (51), un autre angle que la surface latérale (10b) de l'ouverture (10) dans la zone de la couche à conduction p (4).

7. Puce en semiconducteur optoélectronique ou procédé selon l'une des revendications 4 à 6,
la couche de passivation (11) étant générée au moyen d'un processus ALD.

8. Puce en semiconducteur optoélectronique ou procédé selon l'une des revendications 3 à 7,
- au moins deux ouvertures (101, 102) sont formées,
- une surface de raccordement destinée à établir le contact côté N avec la puce en semiconducteur étant formée dans l'une des ouvertures (102), et
- une surface de raccordement destinée à établir le contact côté p avec la puce en semiconducteur étant formée dans l'autre des ouvertures (101).

9. Puce en semiconducteur optoélectronique ou procédé selon l'une des revendications 3 à 7,
les surfaces latérales (5a) de la séquence de couches métalliques (5), à l'exception des ouvertures (10, 101, 102), sont au moins indirectement limitrophes d'une couche métallique (8) qui est reliée électriquement avec le matériau semiconducteur à conduction n (2).

10. Puce en semiconducteur optoélectronique ou procédé selon l'une des revendications 3 à 9,
au moins une ouverture (10, 101, 102) étant entièrement entourée latéralement par une zone active (3).

11. Puce en semiconducteur optoélectronique ou procédé selon l'une des revendications 3 à 9,
- une zone partielle ESD (13) de la puce en semiconducteur, laquelle comprend des parties de la séquence de couches métalliques (5), de la couche à conduction p (4) et de la couche à conduction n (2), est branchée électriquement en tête-bêche avec le reste de la puce en semiconducteur, et
- la zone partielle ESD (13) forme une diode de protection ESD pour le reste de la puce en semiconducteur.

12. Puce en semiconducteur optoélectronique ou procédé selon la revendication précédente,
la zone partielle ESD (13) étant entièrement entourée latéralement par la zone active (3).

13. Puce en semiconducteur optoélectronique ou procédé selon l'une des revendications précédentes, la couche à conduction p (4) dépassant latéralement de la couche réfléchissante (51) et un porte-à-faux (d3) latéral de la couche à conduction p (4) au-dessus de la couche réfléchissante (51) étant au maximum de 5 µm.

14. Puce en semiconducteur optoélectronique selon l'une des revendications 2 à 13,
la puce en semiconducteur étant divisée en au moins deux zones partielles (31) actives qui sont branchées électriquement en série.

15. Puce en semiconducteur optoélectronique selon la revendication précédente,
une liaison électrique (32) entre les zones partielles (31) actives étant disposée au-dessous de la surface de sortie du rayonnement (22) de la puce en semiconducteur.
